# EUROPÄISCHE PATENTSCHRIFT

(11) **EP 1 579 514 B1**
(45) Veröffentlichungstag und Bekanntmachung des Hinweises auf die Patenterteilung: **08.11.2006**
(21) Anmeldenummer: 03814437.4
(22) Anmeldetag: 26.06.2003
(51) Int. Cl.: H01L 41/083, H01L 41/24

(54) **PIEZOAKTOR UND EIN VERFAHREN ZU DESSEN HERSTELLUNG**
PIEZO ACTUATOR AND A METHOD FOR PRODUCING THE SAME
PIEZO-ACTIONNEUR ET SON PROCEDE DE PRODUCTION

(30) Priorität: 23.12.2002 DE 10260853
(43) Veröffentlichungstag der Anmeldung: 28.09.2005
(73) Patentinhaber: ROBERT BOSCH GMBH, 70442 Stuttgart (DE)
(72) Erfinder: SUGG, Bertram, 70839 Gerlingen (DE)
(86) Internationale Anmeldenummer: PCT/DE2003/002132
(87) Internationale Veröffentlichungsnummer: WO 2004/061985

(56) Entgegenhaltungen:
- EP-A- 1 107 325
- EP-A- 1 235 285
- DE-A- 10 021 919
- DE-A- 10 163 005
- DE-A- 10 217 361
- US-A- 5 389 851
- PATENT ABSTRACTS OF JAPAN vol. 1995, no. 04, 31. Mai 1995 (1995-05-31) -& JP 07 007193 A (TOKIN CORP), 10. Januar 1995 (1995-01-10)
- PATENT ABSTRACTS OF JAPAN vol. 015, no. 378 (M-1161), 24. September 1991 (1991-09-24) -& JP 03 151251 A (FUJITSU LTD), 27. Juni 1991 (1991-06-27)

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus zum Teil keramischen Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Solche piezoelektrischen Aktoren eignen sich insbesondere für den Einsatz bei schnellen und präzisen Schaltvorgängen, beispielsweise bei verschiedenen Systemen der Benzin- oder Dieseleinspritzung in Injektoren für Verbrennungsmotoren.

Der Aufbau dieser Piezoaktoren kann hier in mehreren Schichten als sogenannte Multilayer-Piezoaktoren erfolgen, wobei die Innenelektroden, über die die elektrische Spannung aufgebracht wird, jeweils zwischen den Schichten angeordnet werden. Hierzu werden wechselseitig gestapelte Piezofolien mit aufgedruckten Elektrodenflächen als Innenelektroden, hergestellt. Dabei hat eine Folie ihren Anschluss jeweils nur auf einer Anschlussseite und auf der gegenüberliegenden Seite muss ein Rand ohne Innenelektrode mit einem Isolationsabstand verbleiben. Außen werden dann die beiden Seiten durch Außenelektroden verbunden. So entsteht in an sich bekannter Weise der Piezoaktor wie ein Kondensator mit vielen Platten.

In an sich bekannter Weise werden diese Multilayer-Piezoaktoren in einem sogenannten Foliengießverfahren aus Schlicker hergestellt. Die daraus resultierenden sogenannten Grünfolien werden nach dem Stapeln laminiert und anschließend gesintert. Die gewünschte Geometrie erhält man entweder durch Hartbearbeitung im gesinterten Zustand oder durch Formgebung im Grünzustand, also vor dem Sintern. Es ist hier in der Regel notwendig einen Piezoaktor herzustellen, der gegenüber Feuchtigkeit und mechanischer Beschädigung geschützt ist.

Bei den meisten Innenelektrodendesigns treten, wie zuvor erwähnt, an einer Fläche des Piezoaktors jeweils Innenelektroden wechselseitiger Polarität an die Oberfläche. Es besteht hier die Gefahr, dass durch eine unzureichende Isolation oder mechanische Beschädigung beim Transport, beim Verbau oder beim Betrieb Kurzschlüsse zwischen den Elektrodenschichten entstehen. Dem kann zwar durch sogenannte halb- oder vollvergrabene Innenelektrodendesigns begegnet werden. Hierbei werden jeweils nur Innenelektroden einer Polarität oder gar keine Elektroden nach außen an Flächen geführt, die nicht zum Kontaktieren benötigt werden. Allerdings ist dieses Verfahren mit präzisen und damit aufwendigen Stapel- und/oder Trennverfahren verbunden.

Beispielsweise ist aus der DE 199 28 180 A1 bekannt, dass im Bereich zwischen den Kontaktierungen der Außenelektroden die Piezolagen einen vorgegebenen Betrag nach innen ausgespart sind, zur Bildung einer Nut. Diese Nut verhindert beim Bearbeiten der Oberfläche des Piezoaktors und bei der Anbringung der Außenelektroden eine Verschmieren des Elektrodenmaterials zwischen den Außenelektroden und führt daher zu einer deutlichen Verbesserung der Durchschlagfestigkeit des Piezoaktors.

### Vorteile der Erfindung

Der eingangs beschriebene Piezoaktor, der beispielsweise zur Betätigung eines mechanischen Bauteils verwendbar sein kann, ist mit einem Mehrschichtaufbau von Piezolagen und dazwischen angeordneten Innenelektroden aufgebaut. Es wird eine wechselseitige Kontaktierung der Innenelektroden mit Außenelektroden vorgenommen, wobei die Bereiche zwischen den Außenelektroden mit einer geeigneten Isolation versehen sind. Erfindungemäß ist in vorteilhafter Weise im Bereich zwischen den Außenelektroden auf die Außenfläche des Piezoaktors eine isolierende Schicht aus einem vorzugsweise keramischen Material mit nahezu gleichen Eigenschaften wie die Piezolagen, zum Beispiel Schlicker, aufgebracht. In besonders vorteilhafter Weise verwendet man sogar den identischen Schlicker, der auch zum Foliengießen der Piezolagen verwendet worden ist.

Die Außenelektroden können dann auf einfache Weise auf freigeschliffenen Bereichen des isolierenden Materials angebracht werden.

Gemäß eines vorteilhaften Herstellungsverfahrens wird in einem ersten Verfahrensschritt im Grünzustand des Piezoaktors, also vor dem Sintern, die isolierende Schicht vollständig außen auf den Piezoaktor aufgebracht. Der Piezoaktor kann dazu vollflächig in den Schlicker eingetaucht werden. Gegebenenfalls kann der Piezoaktor auch nur an den empfindlichen Seiten beschichtet werden, an den die Innenelektroden beider Polaritäten nach außen treten. Ein geeignetes Verfahren ist hierzu das sogenannte Tauchflut-Verfahren.

Mit der Erfindung kann erreicht werden, dass Beschichtungsdicken im Bereich von typischerweise 50-400 µm gebildet werden. Diese Schichtdicke reduziert sich nach dem Sintern je nach Sinterschwund um 10 -30 %. Eine bestimmte Schichtdicke ist dabei über die Viskosität des Schlickers und/oder durch Mehrfachbeschichten erreichbar. Eine geeignete Schichtdicke stellt hier einen ausreichenden Schichtabstand der Innenelektroden zur Oberfläche sicher und verhindert damit Überschläge zwischen den Innenelektroden. Die Schichtdicke sollte zudem so eingestellt werden, dass diese im Betrieb nicht aufreißt.

Wird zur Herstellung der isolierenden Schutzschicht dasselbe Keramikmaterial wie beim Piezoaktor selbst verwendet, so entsteht beim anschließenden Sintern eine sehr enge und dichte Verbindung zwischen der Keramik der Folienlaminate der Piezolagen und der äußeren isolierenden Schicht, wobei diese Keramikschicht eine wirkungsvolle Schutzhülle des Aktors darstellt. Bei geschlossener Porosität, welche in der Regel bei der verwendeten Piezokeramik vorliegt, ist bei ausreichender Schichtdicke die Keramikschicht sogar feuchtigkeitsundurchlässig. Nach dem Sintern des Piezoaktors werden die Bereiche, an denen die Außenelektroden kontaktiert werden, und gegebenenfalls auch die Stirnflächen, freigelegt. Beispielsweise durch Schleifen oder Ätzen.

Es entsteht somit in vorteilhafter Weise ein kurschlusssicherer Piezoaktor und der Einsatz des Piezoaktors ist auch unter erhöhter Feuchtigkeit gewährleist. Ferner ist ein besseres Handling des Piezoaktors möglich und es ist zur Isolierung keine Lackierung nötig.

### Zeichnung

Ein Ausführungsbeispiel des erfindungsgemäßen Piezoaktors wird anhand der Zeichnung erläutert. Es zeigen:
Figur 1 einen Schnitt durch einen Piezoaktor mit einem Mehrschichtaufbau von Lagen aus Piezokeramik und Elektroden nach dem Stand der Technik,
Figur 2 eine Ansicht auf einen erfindungsgemäßen Piezoaktor mit einer Schutzschicht und mit einer freigelegten Außenelektrode,
Figur 3 einen Schnitt A-A. durch den Piezoaktor nach der Figur 2,
Figuren 4 und 5 einen Querschnitt auf einen Piezoaktor nach dem Sintern und vor und nach dem Freilegen der Außenelektrodenbereiche des Piezoaktor,
Figuren 6 und 7 Draufsichten auf das Innenelektrodendesign des Piezoaktors.

### Beschreibung des Ausführungsbeispiels

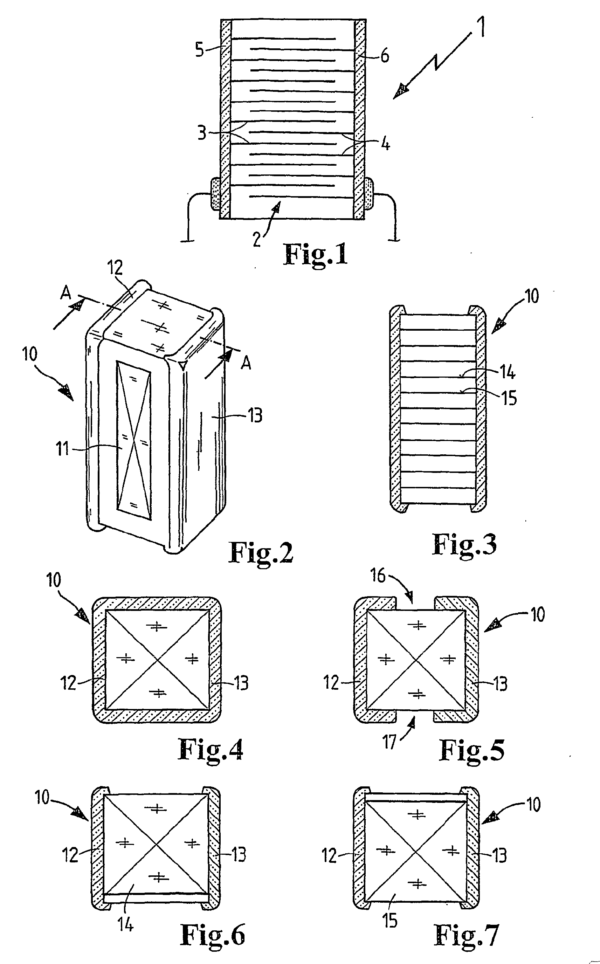

In Figur 1 ist ein Piezoaktor 1 im Prinzip nach dem Stand der Technik gezeigt, der in an sich bekannter Weise aus Piezolagen bzw. Piezofolien 2 eines Quarzmaterials mit einer geeigneten Kristallstruktur aufgebaut ist, so dass unter Ausnutzung des sogenannten Piezoeffekts bei Anlage einer äußeren elektrischen Spannung an Innenelektroden 3 und 4 über Kontaktflächen bzw. Außenelektroden 5 und 6 eine mechanische Reaktion des Piezoaktors 1 erfolgt.

In Figur 2 ist ein erfindungsgemäßer Piezoaktor 10 gezeigt, der im Bereich zwischen den Außenelektroden, hier ist eine Außenelektrode 11 sichtbar, auf seinen Außenflächen isolierende Schichten 12 und 13 aus einem vorzugsweise aus keramischem Material mit nahezu gleichen Eigenschaften wie die Piezolagen 2 trägt, vorzugsweise Schlicker.

Aus Figur 3 ist ein Schnitt A-A nach der Figur 2 zu entnehmen, wobei hieraus die Innenelektroden 14, 15 und die Schichten 12 und 13 ebenfalls entnehmbar sind.

Zur Erläuterung eines Herstellungsverfahrens ist in Figur 4 der sogenannte Grünzustand des Piezoaktors 10, also vor dem Sintern, gezeigt. Die isolierende Schicht 12,13 ist hier zunächst vollständig außen auf den Piezoaktor 10 aufgebracht. Der Piezoaktor 10 kann dazu vollflächig in den Schlicker als Material für die isolierenden Schichten 12 und 13 eingetaucht werden oder der feststehende Piezoaktor 10 kann in einem Bad aus Schlicker benetzt werden, wobei die Füllhöhe des Schlickers an- und abgehoben werden kann.

Figur 5 zeigt den Zustand nach dem Sintern des Piezoaktors 10. Hier werden Bereiche 16 und 17, an den die Außenelektroden 11 kontaktiert werden, durch Schleifen oder Ätzen freigelegt und somit die isolierenden Schichten 12 und 13 gebildet.

Aus Figuren 6 und 7 sind Draufsichten auf das Innenelektrodendesign der Innenelektrode 14 (hier Figur 6) und der Innenelektrode 15 (hier Figur 7) gezeigt. Hier ist erkennbar, dass die Innenelektroden 14 im aus der Figur 5 ersichtlichen Bereich 16 und die Innenelektroden 15 im Bereich 17 mit den jeweiligen Außenelektroden kontaktiert sind.

## Patentansprüche

1. Piezoaktor, mit
- einem Mehrschichtaufbau von Piezolagen (2) und dazwischen angeordneten Innenelektroden (3,4;14,15) und mit
- einer wechselseitigen Kontaktierung der Innenelektroden (3,4;14,15) mit Außenelektroden (5,6;11), wobei die Bereiche zwischen den Außenelektroden (5,6:11) mit einer Isolation (12,13) versehen sind, **dadurch gekennzeichnet, dass**
- im Bereich zwischen den Außenelektroden (5,6;11) auf die Außenfläche des Piezoaktors (1;10) eine isolierende Schicht (12,13) aus demselben Keramikmaterial und damit mit den gleichen Eigenschaften wie die Piezolagen (2) selbst aufgebracht ist.

2. Piezoaktor nach Anspruch 1, **dadurch gekennzeichnet, dass** - die isolierende Schicht (12,13) die Kanten des Piezoaktors (1;10) einschließt.

3. Piezoaktor nach einem der Ansprüche 1 oder 2, **dadurch gekennzeichnet, dass**
- die Außenelektroden (5,6:11) auf freigeschliffenen Bereichen des isolierenden Materials angebracht sind.

4. Verfahren zur Herstellung eines Piezoaktors nach einem der vorhergehenden Ansprüche, **dadurch gekennzeichnet, dass**
- in einem ersten Verfahrensschritt im Grünzustand des Piezoaktors (10) vor dem Sintern die isolierende Schicht (12,13) vollständig außen auf den Piezoaktor (10) aufgebracht wird und
- nach dem Sintern des Piezoaktors (10) die Bereiche (16,17), an denen die Außenelektroden (5,6;11) kontaktiert werden, freigelegt werden.

5. Verfahren nach Anspruch 4, **dadurch gekennzeichnet, dass**
- der Piezoaktor (10) vollflächig oder zweiseitig in die noch flüssige isolierende Schicht eingetaucht oder mit dieser benetzt wird.

6. Verfahren nach Anspruch 4 oder 5, **dadurch gekennzeichnet, dass**
- die Bereiche (16,17), an denen die Außenelektroden (5,6;11) kontaktiert werden, durch Schleifen freigelegt werden.

7. Verfahren nach Anspruch 4 oder 5, **dadurch gekennzeichnet, dass**
- die Bereiche (16,17), an denen die Außenelektroden (5,6;11) kontaktiert werden, durch Ätzen freigelegt werden.

## Claims

1. Piezo actuator, with
- a multilayer structure of piezo layers (2) and internal electrodes (3, 4; 14, 15) arranged in between, and with
- alternating contacting of the internal electrodes (3, 4; 14, 15) with external electrodes (5, 6; 11), the regions between the external electrodes (5, 6; 11) being provided with an insulation (12, 13), **characterized in that**
- in the region between the external electrodes (5, 6; 11) an insulating layer (12, 13) of the same ceramic material, and consequently with the same properties, as the piezo layers (2) themselves is applied to the outer surface of the piezo actuator (1; 10).

2. Piezo actuator according to Claim 1, **characterized in that**
- the insulating layer (12, 13) encloses the edges of the piezo actuator (1; 10).

3. Piezo actuator according to either of Claims 1 and 2, **characterized in that**
- the external electrodes (5, 6; 11) are attached to ground-away regions of the insulating material.

4. Method for producing a piezo actuator according to one of the preceding claims, **characterized in that**
- in a first method step, the insulating layer (12, 13) is completely applied to the outside of the piezo actuator (10) in the green state of the piezo actuator (10), before the sintering, and
- after the sintering of the piezo actuator (10), the regions (16, 17) at which the external electrodes (5, 6; 11) are contacted are bared.

5. Method according to Claim 4, **characterized in that**
- the piezo actuator (1) is immersed completely or on two sides in the still liquid insulating layer or is wetted with the latter.

6. Method according to Claim 4 or 5, **characterized in that**
- the regions (16, 17) at which the external electrodes (5, 6; 11) are contacted are bared by grinding.

7. Method according to Claim 4 or 5, **characterized in that**
- the regions (16, 17) at which the external electrodes (5, 6; 11) are contacted are bared by etching.

## Revendications

1. Actionneur piézo-électrique comprenant
- une structure multicouche de couches piézo-électriques (2) et des électrodes internes (3, 4 ; 14, 15) disposées entre celles-ci, et
- une mise en contact alternante des électrodes internes (3, 4 ; 14, 15) avec des électrodes externes (5, 6 ; 11), les zones entre les électrodes externes (5, 6 ; 11) étant munies d'une isolation (12, 13),
**caractérisé en ce que**
dans la zone entre les électrodes externes (5, 6 ; 11), sur la surface extérieure de l'actionneur piézo-électrique (1 ; 10), est déposée une couche isolante (12, 13) du même matériau céramique ayant par conséquent les mêmes propriétés que les couches piézo-électriques (2) elles-mêmes.

2. Actionneur piézo-électrique selon la revendication 1,
**caractérisé en ce que**
la couche isolante (12, 13) enferme les arêtes de l'actionneur piézo-électrique (1 ; 10).

3. Actionneur piézo-électrique selon l'une quelconque des revendications 1 ou 2,
**caractérisé en ce que**
les électrodes externes (5, 6 ; 11) sont déposées sur des zones du matériau isolant dégagées par meulage.

4. Procédé de fabrication d'un actionneur piézo-électrique selon l'une des revendications précédentes,
**caractérisé en ce que**
- dans une première étape de procédé la couche isolante (12, 13) est entièrement déposée sur l'extérieur de l'actionneur piézo-électrique (10) en son état normal avant frittage, et
- après frittage de l'actionneur piézo-électrique (10) les zones (16, 17) de contact des électrodes externes (5, 6 ; 11) sont dégagées.

5. Procédé selon la revendication 4,
**caractérisé en ce que**
sur toutes ses faces ou sur deux faces l'actionneur piézo-électrique (10) est plongé dans la couche isolante encore liquide ou est mouillé par celle-ci.

6. Procédé selon la revendication 4 ou 5,
**caractérisé en ce que**
les zones (16, 17) de contact des électrodes externes (5, 6 ; 11) sont dégagées par fraisage.

7. Procédé selon la revendication 4 ou 5,
**caractérisé en ce que**
les zones (16, 17) de contact des électrodes externes (5, 6 ; 11) sont dégagées par gravure.
